# EUROPÄISCHE PATENTSCHRIFT

(11) **EP 0 668 712 B1**
(45) Veröffentlichungstag und Bekanntmachung des Hinweises auf die Patenterteilung: **08.11.2000**
(21) Anmeldenummer: 95101655.9
(22) Anmeldetag: 08.02.1995
(51) Int. Cl.: H05K 3/00, H05K 3/40

(54) **Verfahren zum Herstellen von Strukturierungen**
Process for producing structures
Procédé de fabrication de structurations

(30) Priorität: 21.02.1994 CH 50594
(43) Veröffentlichungstag der Anmeldung: 23.08.1995
(73) Patentinhaber: DYCONEX PATENTE AG, 6300 Zug (CH)
(72) Erfinder: Schmidt, Walter, CH-8050 Zürich (CH); Martinelli, Marco, CH-8413 Neftenbach (CH)
(74) Vertreter: Frei, Alexandra Sarah

(56) Entgegenhaltungen:
- EP-A- 0 575 292
- WO-A-93/26143
- US-A- 3 471 631
- US-A- 4 118 523
- US-A- 4 472 238
- US-A- 4 720 322

## Beschreibung

Die Erfindung liegt auf dem Gebiete der Herstellung von Leiterplatten und Folienleiterplatten und betrifft ein gemäss den Patentansprüchen definiertes Verfahren zum Herstellen von Strukturierungen in plasma-ätzbarem Isolatormaterial, welches mit plasma-ätzresistentem Leitermaterial kaschiert ist.

Plasma-ätzbares Isolatormaterial lässt sich nach dem DYCOstrate®-Verfahren in Plasma-Ätz-Verfahren strukturieren. Solche Strukturierungen können Öffnungen sein, die als Durchgangslöcher durch das Isolatormaterial hindurchgehen, es können aber auch Sacklöcher sein, die lediglich in das Isolatormaterial hineinreichen. Durchgangslöcher und Sacklöcher können auch Langlöcher wie Rillen sein, die in unterschiedlichen und in varierenden Tiefen im Isolatormaterial mit geraden oder runden Kanten verlaufen. Beim Plasma-Ätzen werden die Strukturierungen im Isolatormaterial gleichzeitig und mit hoher Genauigkeit erzeugt. Das Verfahren ist wirtschaftlich, denn es ermöglicht ein kostengünstiges und rasches Anbringen vielfältigster Strukturierungen im Isolatormaterial. Als plasma-ätzbares Isolatormaterial werden organische dielektrische Folien wie beispielsweise Polyimidfolien, aramidfaserverstärkte Laminate aus Epoxyd-, Polyimid- oder Cyanat-Ester-Harzfolien, wie auch Folien aus Liquid Crystal Polymers (LCP) usw. verwendet.

Um solches Isolatormaterial örtlich kontrolliert Plasma zu ätzen, wird es mit plasma-ätzresistentem Material beschichtet. Solch Plasma-ätzresistentes Material sind beispielsweise Metallschichten aus Kupfer oder Aluminium, also Schichten aus plasma-ätzresistentem Leitermaterial. Aufgetragenes plasma-ätzresistentes Material wird mit Öffnungen versehen, die bis auf das Isolatormaterial hinabreichen, sodass das Plasma durch diese Öffnungen mit dem Isolatormaterial wechselwirken und ätzen kann.

Da aus thermischen Gründen und auch aus Gründen der damit verbundenen niedrigen Plasma-Ätzrate, gerichtetes Plasma-Ätzen (Reactive Ion Etching oder RIE) bei der Herstellung von Folienleiterplatten nicht sinnvoll erscheint, wird ein isotropes Plasma-Ätzen verwendet, d.h. Isolatormaterial wird überall und gleichmässig dort entfernt, wo das Plasma Zugang zum ihm hat. Das Isolatormaterial kann also auch unterhalb der Ränder der Öffnungen im plasma-ätzresistenten Material, also unterhalb des plasma ätzresistenten Materials entfernt werden. Diese Unterätzung führt dazu, dass die Ränder der Öffnungen von festem oder starrem plasma ätzresistenten Material nach dem Plasma-Ätzen quasi isoliert im Raum vorstehen und dass das Isolatormaterial hinterätzte Hohlräume besitzt.

Nun erweist sich die Verwendung von plasma-ätzresistentem Leitermaterial, das fest mit plasma-ätzbarem Isolatormaterial verbundenen ist, als vorteilhaft bei der Herstellung von Leiterplatten und Folienleiterplatten. Solch Leitermaterial kann als kaschierte Kupferschichten ein- und beidseitig auf Isolatormaterial aufgebracht sein. Nach dem Plasma-Ätzen von Öffnungen im Isolatormaterial lässt sich das Leitermaterial in weiteren Verfahrenschritten in Strompfade strukturieren, die Öffnungen im Isolatormaterial lassen sich aufplattieren, um so Durchplattierungen zwischen verschiedenen Ebenen strukturierten Leitermaterials zu bilden.

Andererseits erweisen sich Hinterätzungen, also die vorstehenden Ränder oder Stege plasma-ätzresistenten Materials um Öffnungen in Isolatormaterial als nachteilig für weitere, darauffolgende Verarbeitungsschritte. So treten beim galvanischen Abscheiden von Kupfer die folgenden Probleme auf:
- Der Bereich unterhalb der Stege um Öffnungen in Isolatormaterial wird beim galvanischen Abscheiden von Metallschichten elektrisch abgeschirmt, sodass dort nur geringe Kupfermengen abgeschieden werden, wodurch beispielsweise die Zuverlässigkeit von Durchplattierungen nicht gewährleistet ist.
- Die hinterätzten Hohlräume der Öffnungen in Isolatormaterial lassen sich nur ungenügend reinigen, beispielsweise durch Entgasen oder durch Ausspülen. Beim galvanischen Abscheiden mit der Vielzahl von aufeinanderfolgenden Bädern führt dies zu ungenügenden Resultaten und zum Verschleppen von Chemikalien von einem Bad zum nächsten.
- Die Stege um Öffnungen in Isolatormaterial sind dünn und mechanisch leicht verformbar. Beispielsweise werden sie durch Ultraschallbäder als Reinigungsmittel aufgebogen und deformiert. Dies führt zu mangelhaften Ergebnissen bei nachfolgenden photochemischen Verfahrensschritten.

Eine Möglichkeit solche Unterätzungen zu beheben besteht darin, die Stege um plasma-geätzte Öffnungen durch Druck-Beaufschlagung in diese Öffnungen im Isolatormaterial einzudrücken, wie es beispielsweise in der Patentschrift U.S. 4.472.238 beschrieben wird. In dieser Schrift werden beidseitig kupferkaschierte Polyimid-Folien, wie Pyralux® Du Pont F9111 oder mit Kupferfolien beschichtetes Kevlar® als plasma-ätzresistentes Leitermaterial und plasma-ätzbares Isolatormaterial verwendet. Vorstehende Kupferränder von 76-254 µm grossen Löchern in den Polyimid- oder Kevlarfolien werden bei 124 atm Überdruck in diese Löcher eingedrückt.

Das Verfahren hat gravierende Nachteile. Je feiner die plasmageätzten Strukturen sind - die untergeätzt werden - desto grössere Überdrucke müssen angelegt werden, um die Stege in die Öffnungen einzudrücken. Dies führt zu übermässigen mechanischen Belastungen und unerwünschten Dimensionsänderungen und ist daher technisch unpraktikabel.

Eine weitere Möglichkeit diese Unterätzungen zu beheben besteht darin, die Stege um plasma-geätzte Öffnungen durch Materiebeschuss in diese Öffnungen im Isolatormaterial einzudrücken. Ein solches Verfahren ist in der Leiterplattentechnik als Jet-Scrubber Verfahren bekannt, bei dem beispielsweise eine wässrige Lösung aus Bimssteinpulver unter Hochdruck auf die vorstehende Ränder von Öffnungen gesprüht wird und diese in die Öffnungen drückt.

Auch dieses Verfahren hat gravierende Nachteile. Es findet eine mechanische Kaltverformung der Bimsteinpulver-bestrahlten Oberflächen statt, die zu unerwünschten mechanischen Spannungen und Dimensionsänderungen führt. Das Verfahren ist nur mit sehr dünnen Schichten plasma-ätzresistenten Leitermaterials anwendbar. Es findet der teilweise Einbau von Bimssteinpulver und von losgeschlagenen Partikeln plasma-ätzresistenten Materials in anderen Bereichen der herzustellenden Leiterplatte und Folienleiterplatte statt, was wiederum zu störenden Effekten wie Verunreinigungen, elektrischen Kurzschlusskontakten usw führt. Dieses Verfahren ist technisch unpraktikabel.

Die Schrift US-3,471,631 zeigt ein Verfahren zur Herstellung von mehrlagigen Leiterplatten unter Verwendung von kupferlaminierten Epoxydglasplatten mit auflaminierten Kupferschichten. In die Epoxydglasplatten werden Sacklöcher geätzt; wobei an Sacklochrändern einer ersten Kupferschicht Hinterätzungen entstehen. Diese Hinterätzungen werden entfernt indem diese Ränder der ersten Kupferschicht gezielt chemisch geätzt werden. Andere freiliegende Bereiche der beiden Kupferschichten werden durch geeignete Mittel vor einem Ätzangriff geschützt.

Ein weiteres Verfahren zur Herstellung von mehrlagigen Leiterplatten wird in der Patentschrift US-4,118,523 gezeigt. Unterätzungen in mit Metallschichten auflaminiertem Dielektrikum werden entfernt, indem um Löcher mit vorstehenden Metallrändern photochemisch Metallringe strukturiert werden und die Metallringe daraufhin durch Ätzen entfernt werden. Zum Entfernen überstehender Metallränder wird eine spezielle photochemische Strukturierung benötigt.

Es ist nun Aufgabe der Erfindung, einen Ausweg aus dieser Problematik aufzuzeigen. Die Erfindung soll ein Herstellen von Strukturierungen in ätzbarem Isolatormaterial, das mit Leitermaterial kaschiert ist, ermöglichen. Insbesondere soll ein betriebssicheres Herstellen von Strukturierungen im Leitermaterial möglich sein. Dies soll in verhältnismässig wenig Arbeitsschritten erfolgen und es sollen dabei etablierte und bewährte Verarbeitungsschritte verwenden werden.

Diese Aufgabe wird durch die Erfindung, wie sie in den unabhängigen Patentansprüchen 1, 3, 13 und 1 definiert ist, gelöst. Besondere Ausführungsformen sind in den abhängigen Asprüchen dargestellt.

Die Idee der Erfindung entstand im Ärger über die nachteiligen Wirkungen von Unterätzungen und beim Versuch, solche Unterätzungen zu vermeiden. In der Regel sind sie unerwünscht und tangieren die Produktqualität beträchtlich. Bei der vorliegenden Erfindung werden sie gezielt herbeigeführt um Strukturierungen in einem Isolatormaterial zu erzeugen und sie werden genauso gezielt wieder behoben, um Strukturierungen in einem Leitermaterial zu erzeugen. Die Erfindung besteht darin, nachteilige Schwachstellen von Strukturierungen im einen Material und erzeugt durch ein erstes Verfahren, als vorteilhafte Schwachstellen bei der Erzeugung von Strukturierungen im anderen Material durch ein zweites Verfahren zu benutzen, derart dass die Schwachstellen aufgehoben werden und die Produktqualität optimiert wird.

In der Erfindung werden zwei unterschiedliche Strukturier-Verfahren nacheinander angewendet. Zuerst erfolgt ein Plasma-Ätz-Verfahren oder es erfolgt ein chemisches Ätz-Verfahren zum Strukturieren des Isolatormaterials während das Leitermaterial unberührt bleibt. Dann erfolgt ein chemisches Ätz-Verfahren oder es erfolgt ein galvanisches Abtrag-Verfahren (Elektroplattier-Verfahren) zum Strukturieren des Leitermaterials, während das Isolatormaterial nicht angegriffen wird. Beide Strukturier-Verfahren sind isotrope Prozesse. Beide Strukturier-Verfahren gleichen sich in ihrer Wirkung aus. Alle für weitere Verarbeitungsschritte nachteiligen Hinterätzungen, erzeugt durch das Plasma-Ätzen-Verfahren oder durch das chemische Ätz-Verfahren des Isolatormaterials, werden im chemischen Ätz-Verfahren oder sie werden im galvanischen Abtrag-Verfahren (Elektroplattier-Verfahren) des Leitermaterials abgetragen.

Die Erfindung betrifft ein Verfahren zum Herstellen von Leiterplatten und Folienleiterplatten aus Ausgangsprodukten und über Zwischenprodukte. Die Ausgangsprodukte bestehen aus ätzbarem Isolatormaterial, welches ein- oder beidseitig mit Leitermaterial beschichtet ist. In einem ersten Verfahrensschritt werden Öffnungen im Isolatormaterial gemäss vorbereiteten Öffnungen im Leitermaterial plasma-geätzt oder chemisch geätzt, wobei die Ränder dieser vorbereiteten Öffnungen hinterätzt werden. Die vorbereiteten Öffnungen im Leitermaterial und die Öffnungen im Isolatormaterial werden gezielt hinterätzt strukturiert. In einem zweiten Verfahrensschritt werden die vorstehenden Ränder chemisch weggeätzt oder galvanisch (durch Elektroplattieren) entfernt. Die vorbereiteten Öffnungen im Leitermaterial und die Öffnungen im Isolatormaterial sind somit gezielt hinterätzungsfrei strukturiert. Auf diese Weise werden Zwischenprodukte gebildet, die beispielsweise nach Aufplattierung zu Leiterplatten und Folienleiterplatten weiterverarbeitet werden können.

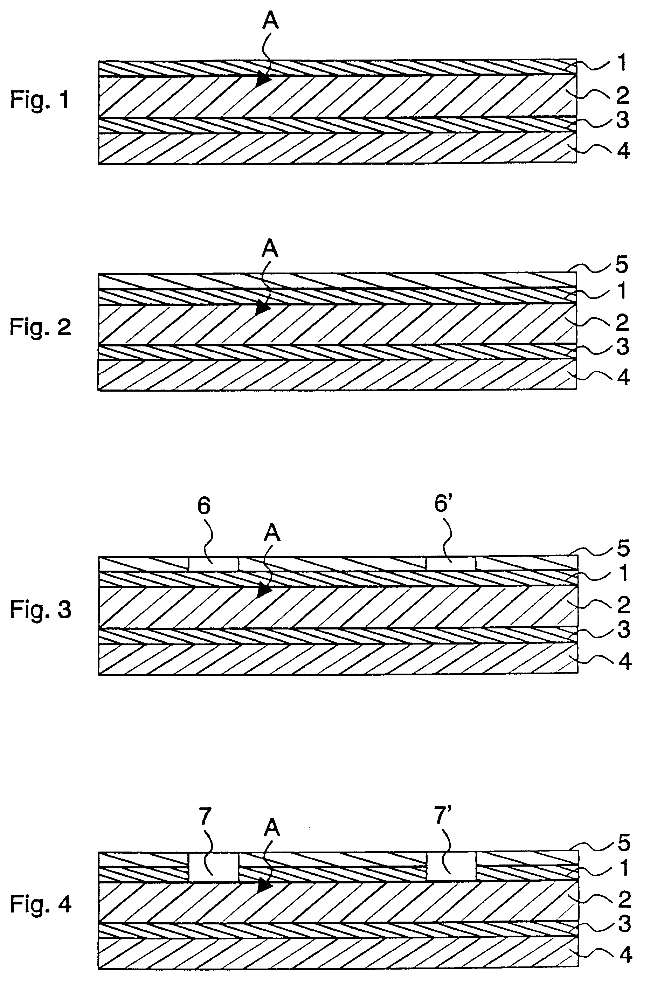

Anhand der nachfolgenden **Figuren 1 bis 8** wird das erfindungsgemässe Verfahren zur Herstellung von Strukturierungen näher erläutert. Die Figuren 1 bis 8 zeigen schematisch das erfindungsgemässe Verfahren zum Entfernen hinterätzter vorstehender Ränder des Leiteraterials um Öffnungen in ätzbarem Isolatormaterial.

**Figur 1** zeigt ein Ausgangsprodukt A zum Herstellen von Leiterplatten und Folienleiterplatten. Das Ausgangsprodukt A ist ein Multilayer, bestehend aus einer Schicht ätzbaren Isolatormaterial 2, welches beidseitig mit Leitermaterial 1,3 beschichtet ist. Als plasma-ätzbares oder chemisch ätzbares Isolatormaterial 2 werden organische dielektrische Folien wie beispielsweise Polyimid- oder Acrylatfolien, aramidfaserverstärkte Laminate aus Epoxyd-, Polyimid- oder Cyanat-Ester-Harzfolien, wie auch Folien aus Liquid Crystal Polymers (LCP) verwendet. Dieses Isolatormaterial 2 wird durch bekannte Plasmaätz-Medien oder durch bekannte chemische Ätz-Medien wie beispielsweise KMnO₄, NaOH, KOH + Alkohol, H₂SO₄, H₃PO₄ usw. in Öffnungen mit Hinterätzungen strukturiert. Das Leitermaterial 1,3 besteht aus elektrisch leitenden Schichten, beispielsweise aus Metallschichten, wie Kupfer, Aluminium, Silber. Das Leitermaterial 1,3 ist auf das Isolatormaterial 2 auflaminiert oder auf diesem galvanisch bzw. durch Aufdampfen oder Aufsputtern oder durch Plasma-aktivierte Gasphasenabscheidung (PECVD) aufgebracht und mechanisch fest verbunden. Das Ausgangsprodukt A selbst ist auf ein Trägersubstrat 4 auflaminiert und mit diesem mechanisch fest verbunden.

In vorteilhaften Ausführungsformen von Ausgangsprodukten A zum Herstellen von Folienleiterplatten sind diese Schichten Isolatormaterial 2 und Leitermaterial 1,3 aus bestimmten vorteilhaften Materialien und besonders dünn ausgebildet. So besteht das Ausgangsprodukt A vorteilhafterweise aus einer beidseitig kupferkaschierten Polymerfolie, bei der die Polymerschicht 25-50 µm dick ist und die Kupferschichten 8 bis 12 µm dick sind. Natürlich können Ausgangsprodukte A zum Herstellen von Leiterplatten auch aus wesentlich dickeren Schichten Isolatormaterial und Leitermaterial bestehen

**Figur 2** zeigt ein Ausgangsprodukt A gemäss Figur 1 nach Aufbringen einer Schicht Photoresist 5 auf die Schicht Leitermaterial 1, sodass diese vollständig mit Photoresist bedeckt ist. Es kann festes oder flüssiges Photoresist verwendet werden. Das Photoresist 5 kann in bekannten photochemischen Verfahren belichtet werden. Ein Öffnungsentwurf wird über Photomasken in das Photoresist 5 übertragen. Der Öffnungsentwurf beinhaltet Position und Struktur der herzustellenden Öffnungen oder Strukturierungen im Isolatormaterial 2.

**Figur 3** zeigt die gemäss dem Öffnungsentwurf photochemisch durchgeführte Strukturierung der Schicht Photoresist 5. In der strukturierten Schichten Photoresist 5 sind Öffnungsstrukturen 6,6' gebildet, welche bis auf die Schicht Leitermaterial 1 herabreichen. Die anderen, mit Photoresist bedeckten Bereiche der Schicht Leitermaterial 1 werden in den folgenden photochemischen Bearbeitungsschritten vor dem nasschemischen Ätzen geschützt. Die flächige Grösse der Öffnungsstrukturen liegt im Bereich von 10 -100µm. Die Formen der Flächen sind frei wählbar, sie können als kreiszylindrische, runde, ovale und auch quadratische, rechteckige, mehreckige Flächen ausgebildet werden.

**Figur 4** zeigt die mit einer photochemisch strukturierten Schicht Photoresist 5 bedeckte Schicht Leitermaterial 1 nach erfolgtem nasschemischen Ätzen des von Photoresist 5 unbedeckten Leitermaterial 1. Dieses Ätzen erfolgt gemäss dem Öffnungsentwurf nur im Bereich der Öffnungsstrukturen 6,6' und führt zur gezielten Bildung von vorbereiteten Öffnungen 7,7' im Leitermaterial 1 welche bis auf das Isolatormaterial 2 hinabreichen. Solche Schablonen werden durch das Ätzmedium nicht angegriffen und das Ätzmedium kann nur in Bereichen von Öffnungen in diesen Schablonen an das zu ätzende Leitermaterial 1 gelangen.

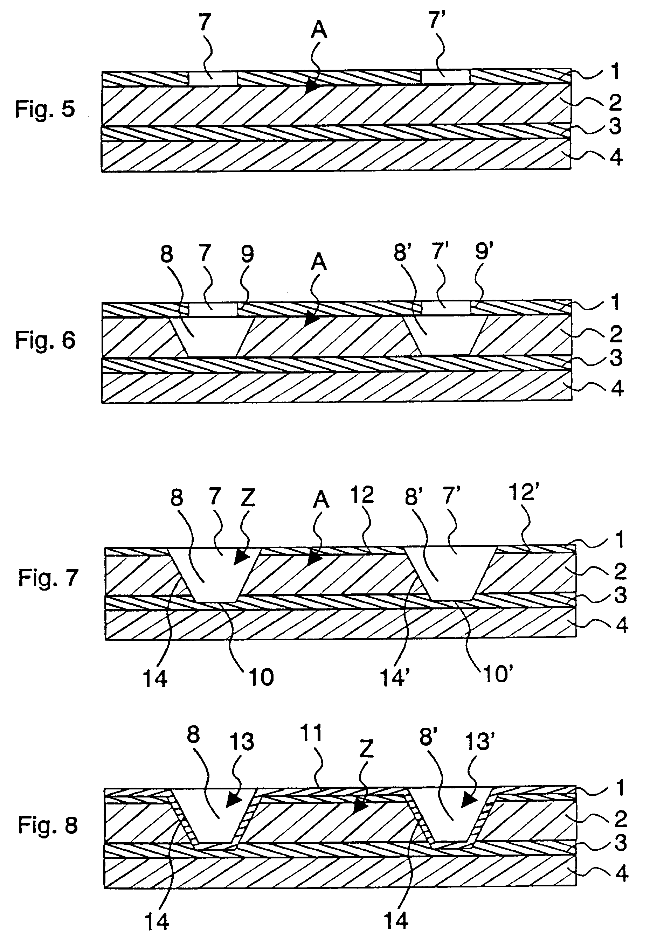

In **Figur 5** sieht man das sich im Herstellungsstadium gemäss Figur 4 befindliche Ausgangsprodukt A nach Entfernen des Photoresists 5. Dies geschieht mittels bekannter und bewährter chemischer Prozesse. Dieser Schritt ist fakultativ, da das Photoresist 5 je nach Art und Dauer des folgenden Plasma-Ätzens des Isolatormaterials 2, mehr oder weniger vollständig entfernt wird.

In **Figur 6** sieht man das von Photoresist gesäuberte Ausgangsprodukt A nach dem Plasma-Ätzen oder chemischen Ätzen von Öffnungen oder Strukturierungen 8,8' durch das Isolatormaterial 2 hindurch, welche bis auf die Schicht Leitermaterial 3 hinab reichen. In diesem ersten Verfahrensschritt wird ätzbares Isolatormaterial 2, isotrop gemäss der vorbereiteten Öffnungen 6,6' der kaschierten Schicht Leitermaterial 1 geätzt. Dort wo das Plasma oder das chemische Ätzmedium mit Isolatormaterial 2 in Kontakt kommt, entstehen Öffnungen, das Leitermaterial 1 wird hinterätzt und weist an diesen Öffnungen vorstehende Ränder oder Stege 9,9' auf. Diese vorstehenden Ränder 9,9' säumen die Strukturierungen 8,8' im Isolatormaterial 2 und stehen quasi isoliert im Raum.

**Figur 7** zeigt das Ausgangsprodukt A mit hinterätzten Öffnungen oder Strukturierungen 8,8' im Isolatormaterial 2 nach Durchätzen der Stege 9,9' der oberen, strukturierten Schicht Leitermaterial 1. In diesem zweiten Herstellungsschritt wird das Leitermaterial 1,3 isotrop chemisch geätzt oder galvanisch, durch Elektroplattieren, entfernt. D.h. dort wo die Chemikalien mit Leitermaterial 1,3 in Kontakt kommt, werden diese weggeätzt.

Das chemische Ätzen oder das galvanische Abtragen (Elektroplattieren) erfolgt auf allen für Chemikalien zugänglichen Oberflächenbereichen gleichmässig. Die quasi isoliert im Raum vorstehenden Ränder 9,9' der Schicht Leitermaterials 1 weisen ein grosses Oberflächen/Volumen-Verhältnis auf und sind für die Chemikalien besonders gut erreichbar und werden chemisch weggeätzt oder durch Elektroplattieren entfernt, während die anderen nicht hinterätzten Oberflächenbereiche 12,12' der Schichten Leitermaterial 1,3 lediglich chemisch oder galvanisch (durch Elektroplattieren) abgedünnt werden. So werden die exponierten Oberflächenbereiche der unteren Schicht Leitermaterial 3, die ja die Böden 10,10' der Öffnungen 8,8' im Isolatormaterial 2 bilden, gleichmässig dünner geätztoder dünner elektroplattiert, sie werden aber nicht entfernt sondern nur abgedünnt.

Die chemischen Ätzparameter und die Elektroplattierparameter sind so gewählt, dass das Leitermaterial 1,3 abgeätzt bzw. durch Elektroplattieren entfernt wird, dass das Leitermaterial 1,3 eine mechanisch stabilisierende und eine elektrisch leitende Funktion für das Ausgangsprodukt A erfüllt, dass die vorstehenden Ränder 9,9' des Leitermaterials 1,3 vollständig weg- oder durchgeätzt bzw. weg- oder durchelektroplattiert werden. Die Hinterätzungen aus dem ersten Verfahrensschritt werden somit gezielt bereinigt, sodass ein Zwischenprodukt Z hergestellt wird. Die Öffnungen 8,8' gemäss Figur 7 können beispielsweise als Sacklöcher oder Rillen ausgeformt sein. Bei Verwendung von beispielsweise rund 10 µm dicken Schichten Leitermaterial 1,3 aus Kupfer werden die vorstehenden Ränder 9,9' von allen Seiten gleichzeitig geätzt bzw. elektroplattiert werden, sie sind somit schon entfernt, wenn auf den anderen, abgedeckten und somit nicht hinterätzten Oberflächenbereichen Leitermaterial 1,3 lediglich erst rund 5 µm abgeätzt bzw. durch Elektroplattieren entfernt ist. Es liegen also unterschiedlich dicke Bereiche Leitermaterial 1,3 vor. Dem Fachmann ist es bei Kenntnis der vorliegenden Erfindung ein leichtes, die chemischen Ätzparameter bzw. die Elektroplattierparameter für die jeweiligen verwendeten Materialien und für deren Materialstärken auszuwählen, sodass dieser zweite Verfahrensschritt dann oder genau dann beendet wird, wenn nachteilige, vorstehende Ränder um geätzte Öffnungen von Leitermaterial vollständig entfernt sind. Solch chemisches Ätzen bzw. Elektroplattieren sind in der Leiterplattenindustrie bewährte und bestens bekannte Methoden. Beispielsweise können Kupferschichten 1,3 durch Natriumpersulfat oder auch Kupferchlorid und Wasserstoffperoxid geätzt werden. Die Abtragsrate wird dabei durch die Expositionszeit und die Temperatur des Ätzmediums sehr präzise gesteuert.

**Figur 8** zeigt das Zwischenprodukt Z gemäss Figur 7 nach dem Aufplattieren einer Schicht elektrisch leitfähigen Materials 11. Dieser Verfahrensschritt ist optional und dient dazu, entweder die chemisch dünner geätzten bzw. durch Elektroplattieren abgedünnten Schichten Leitermaterials 1,3 mechanisch zu verstärken und/oder elektrisch zu verbinden. Als elektrisch leitfähiges Material 11 können beispielsweise dünne Metallschichten aus Kupfer oder Paladium aufplattiert werden.

Das Zwischenprodukt Z eignet sich zum Herstellen von Leiterplatten und Folienleiterplatten. Mit den somit verstärkten Schichten Leitermaterial 1,3,11 kann es beispielsweise im DYCOstrate®-Verfahren in Strompfade und Durchplattierungen strukturiert werden. Solche Strukturierungen können Strompfade in Schichten Leitermaterial sein und es können aber auch Durchplattierungen in Öffnungen von Schichten Isolatormaterial sein, sodass unterschiedliche Schichten strukturiertes Leitermaterial miteinander elektrisch verbunden werden können. Hier stehen dem Fachmann bei Kenntnis der vorliegenden Erfindung eine Vielzahl an Möglichkeiten der Realisierung offen.

Die Öffnungen 8,8' gemäss Figur 8 sind Sacklöcher mit schrägen Wandungen 14,14' relativ zur flächigen Ausdehnung des Zwischenprodukts Z, die nach der Aufplattierung die Schichten Leitermaterial 1 und 3 als Durchplattierung 13,13' elektrisch miteinander verbinden und dementsprechend schräge Wandungen 14,14' relativ zur flächigen Ausdehnung des Zwischenprodukts Z aufweisen. Solch schräge Wandungen 14,14' lassen sich in weiteren Herstellungsschritten besser photochemisch strukturieren. Auch lassen sind solch schräge Wandungen 14,14' besser reinigen. Schliesslich sind solch schräge Wandungen 14,14' zuverlässiger gegen störende, äussere Einflüsse. Bei Ausdehnung der Schicht Isolatormaterial 2 in z-Richtung, beispielsweise infolge Temperaturerhöhung beim Löten usw., reissen schräge Wandungen nicht so leicht an Ecken und Kanten ab wie senkrechte Wandungen.

Schräge Wandungen 14,14' sind bei der photochemischen Strukturierung durch die mit elektrisch leitfähigem Material 11 aufplattierten vorbereiteten Öffnungen 7,7' im Leitermaterial 1 hindurch besser zugänglich. Auch lässt sich negativ arbeitender Photoresist verwenden, der in den Durchplattierungen 13,13' belichtet werden kann und der wesentlich billiger und empfindlicher als positiv arbeitender Photoresist ist. Die höhere Empfindlichkeit hat den grossen Vorteil, dass geringere Belichtungsintensitäten benötigt werden und dass schneller belichtet werden kann.

Das in den Figuren 1 bis 5 gezeigt Anbringen vorbereiteter Öffnungen 7,7' in der einen Schicht Leitermaterial 1 kann gleichzeitig und vollkommen analog natürlich auch in der zweiten Schicht Leitermaterial 3 durchgeführt werden. Für diesen Zweck wird das Zwischenprodukt Z zumindestens in hierfür vorgesehenen Oberflächenbereichen nicht auf das Trägersubstrat 4 auflaminiert, sodass dort die Schicht Leitermaterial 3 mit Photoresist beschichtet werden kann. Nun wird diese Schicht Photoresist in Öffnungsstrukturen strukturiert und in chemischen Ätz-Verfahren bzw. durch Elektroplattieren werden entsprechend dieser Öffnungsstrukturen vorbereiteten Öffnungen in der Schicht Leitermaterial geätzt. In Plasma-Ätz-Verfahren oder in chemischen Ätz-Verfahren werden dann entsprechend dieser vorbereiteten Öffnungen in der Schicht Leitermaterial Öffnungen oder Strukturierungen im Isolatormaterial geätzt. Solche Strukturierungen können dann schräge Wandungen relativ zur flächigen Ausdehnung des Zwischenprodukts Z verlaufende Durchgangslöcher aufweisen. Im Verfahrensschritt gemäss Figur 8 lassen sie sich zu Durchplattierungen aufplattieren und weisen dann schräge Wandungen relativ zur flächigen Ausdehnung des Zwischenprodukts Z auf.

Im folgenden werden zusammenfassend noch einmal Beispiele von Varianten des erfindungsgemässen Verfahrens zum Herstellen von Leiterplatten und Folienleiterplatten aufgezeigt:
- In einer ersten Variante werden Öffnungen 8,8' im Isolatormaterial 2 gemäss vorbereiteten Öffnungen 7,7' im Leitermaterial 1,3 in einem ersten Verfahrensschritt in einem Plasma-Ätz-Verfahren strukturiert, derart, dass vorstehende Ränder 9,9' der vorbereiteten Öffnungen 7,7' durch Hinterätzung gebildet werden. In einem zweiten Verfahrensschritt, in einem chemischen Ätz-Verfahren, werden die vorstehenden Ränder 9,9' des Leitermaterials 1,3 entfernt (beispielsweise werden Kupferschichten 1,3 durch Natriumpersulfat oder auch Kupferchlorid und Wasserstoffperoxid geätzt), sodass die vorbereiteten Öffnungen 7,7' und die Öffnungen 8,8' gezielt hinterätzungsfrei strukturiert sind.
- In einer weiteren Variante werden Öffnungen 8,8' im Isolatormaterial 2 gemäss vorbereiteten Öffnungen 7,7' im Leitermaterial 1,3 in einem ersten Verfahrensschritt in einem Plasma-Ätz-Verfahren strukturiert, derart, dass vorstehende Ränder 9,9' der vorbereiteten Öffnungen 7,7' durch Hinterätzung gebildet werden. In einem zweiten Verfahrensschritt, in einem galvanischen Abtrag-Verfahren (Elektroplattier-Verfahren), werden die vorstehenden Ränder 9,9' des Leitermaterials 1,3 entfernt, sodass die vorbereiteten Öffnungen 7,7' und die Öffnungen 8,8' gezielt hinterätzungsfrei strukturiert sind.
- In einer weiteren Variante werden Öffnungen 8,8' im Isolatormaterial 2 gemäss vorbereiteten Öffnungen 7,7' im Leitermaterial 1,3 in einem ersten Verfahrensschritt, in einem chemischen Ätz-Verfahren, strukturiert (beispielsweise werden Polyimid- oder Acrylatfolien, aramidfaserverstärkte Laminate aus Epoxyd-, Polyimid- oder Cyanat-Ester-Harzfolien, wie auch Folien aus Liquid Crystal Polymers (LCP) als Isolatormaterial 2 verwendet und durch bekannte chemische Ätz-Medien wie beispielsweise KMnO₄, NaOH, KOH + Alkohol, H₂SO₄, H₃PO₄ geätzt), derart, dass vorstehende Ränder 9,9' der vorbereiteten Öffnungen 7,7' durch Hinterätzung gebildet werden. In einem zweiten Verfahrensschritt, in einem chemischen Ätz-Verfahren, werden die vorstehenden Ränder 9,9' des Leitermaterials 1,3 entfernt (beispielsweise werden Kupferschichten 1,3 durch Natriumpersulfat oder auch Kupferchlorid und Wasserstoffperoxid geätzt), sodass die vorbereiteten Öffnungen 7,7' und die Öffnungen 8,8' gezielt hinterätzungsfrei strukturiert sind.
- In einer weiteren Variante werden Öffnungen 8,8' im Isolatormaterial 2 gemäss vorbereiteten Öffnungen 7,7' im Leitermaterial 1,3 in einem ersten Verfahrensschritt, in einem chemischen Ätz-Verfahren, strukturiert (beispielsweise werden Polyimid- oder Acrylatfolien, aramidfaserverstärkte Laminate aus Epoxyd-, Polyimid- oder Cyanat-Ester-Harzfolien, wie auch Folien aus Liquid Crystal Polymers (LCP) als Isolatormaterial 2 verwendet und durch bekannte chemische Ätz-Medien wie beispielsweise KMnO₄, NaOH, KOH + Alkohol, H₂SO₄, H₃PO₄ geätzt), derart, dass vorstehende Ränder 9,9' der vorbereiteten Öffnungen 7,7' durch Hinterätzung gebildet werden. In einem zweiten Verfahrensschritt in einem galvanischen Abtrag-Verfahren (Elektroplattier-Verfahren) werden die vorstehenden Ränder 9,9' des Leitermaterials 1,3 entfernt, sodass die vorbereiteten Öffnungen 7,7' und die Öffnungen 8,8' gezielt hinterätzungsfrei strukturiert sind.

## Patentansprüche

1. Verfahren zum Herstellen von Zwischenprodukten (Z) für Leiterplatten und Folienleiterplatten, aus auf ein Trägersubstrat (4) auflaminierten Ausgangsprodukten (A) aus ätzbarem Isolatormaterial (2), welches Isolatormaterial (2) beidseitig mit jeweils einer Schicht Leitermaterial (1,3) beschichtet ist,
wobei in einem ersten Verfahrensschritt Öffnungen (8,8') im ätzbaren Isolatormaterial (2) gemäss vorbereiteten Öffnungen (7,7') in der ersten Schicht Leitermaterial (1) geätzt werden, wobei diese Öffnungen (8,8 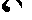 ) im ätzbaren Isolatormaterial (2) unter die Ränder der vorbereiteten Öffnungen (7,7') in der ersten Schicht Leitermaterial (1) reichen und vorstehende Ränder (9,9') in der ersten Schicht Leitermaterial (1) gebildet werden und diese Öffnungen (8,8 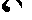 ) im ätzbaren Isolatormaterial (2) bis zur zweiten Schicht Leitermaterial (3) reichen und Böden (10,10 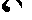 ) der Öffnungen (8,8') durch diese zweite Schicht Leitermaterial (3) gebildet werden,
**dadurch gekennzeichnet,**
dass im ersten Verfahrensschritt die Öffnungen (8,8') ) im ätzbaren Isolatormaterial (2) mit soviel gezielter Hinterätzung mittels chemischem Ätzen oder Plasma-Ätzen hergestellt werden, dass schräge, photochemisch strukturierbare Wände (14,14') bezüglich der flächigen Ausdehnung des Ausgangsprodukts (A) erzielt werden, dass in einem zweiten Verfährensschritt die Schichten Leitermaterial (1,3) entsprechend der lokalen Oberflächen/Volumen-Verhältnisse mittels nasschemischem Ätzen oder elektrochemisch durch gleichmässige Dickenreduktion abgetragen werden, wobei gleichzeitig exponierte Bereiche der ersten Schicht Leitermaterial (1) sowie die Böden (10,10 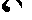 ) in der zweiten Schicht Leitermaterial (3) in ihrer Dicke reduziert werden, und zwar nur soweit, bis die vorstehenden Ränder (9,9') in der ersten Schicht Leitermaterial (1) entfernt sind.

2. Verfahren gemäss Anspruch 1, **dadurch gekennzeichnet,** dass derart hergestellte Zwischenprodukte (Z) mit elektrisch leitfähigem Material (11) aufplattiert werden, so dass die verschiedenen Schichten Leitermaterial (1,3) elektrisch miteinander verbunden sind.

3. Verfahren zum Herstellen von Leiterplatten und Folienleiterplatten, aus auf ein Trägersubstrat (4) auflaminierten Ausgangsprodukten (A) aus ätzbarem Isolatormaterial (2), welches Isolatormaterial (2) beidseitig mit jeweils einer Schicht Leitermaterial (1,3) beschichtet ist,
wobei in einem ersten Verfahrensschritt Öffnungen (8,8') im ätzbaren Isolatormaterial (2) gemäss vorbereiteten Öffnungen (7,7') in der ersten Schicht Leitermaterial (1) geätzt werden, wobei diese Öffnungen (8,8 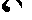 ) im ätzbaren Isolatormaterial (2) unter die Ränder der vorbereiteten Öffnungen (7,7') in der ersten Schicht Leitermaterial (1) reichen und vorstehende Ränder (9,9') in der ersten Schicht Leitermaterial (1) gebildet werden und diese Öffnungen (8,8 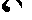 ) im ätzbaren Isolatormaterial (2) bis zur zweiten Schicht Leitermaterial (3) reichen und Böden (10,10 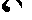 ) der Öffnungen (8,8') durch diese zweite Schicht Leitermaterial (3) gebildet werden,
**dadurch gekennzeichnet,**
dass im ersten Verfahrensschritt die Öffnungen (8,8') ) im ätzbaren Isolatormaterial (2) mit soviel gezielter Hinterätzung mittels chemischem Ätzen oder Plasma-Ätzen hergestellt werden, dass schräge, photochemisch strukturierbare Wände (14,14') bezüglich der flächigen Ausdehnung des Ausgangsprodukts (A) erzielt werden, dass in einem zweiten Verfahrensschritt die Schichten Leitermaterial (1,3) entsprechend der lokalen Oberflächen/Volumen-Verhältnisse mittels nasschemischem Ätzen oder elektrochemisch durch gleichmässige Dickenreduktion abgetragen werden, wobei exponierte Bereiche der ersten Schicht Leitermaterial (1) sowie die Böden (10,10 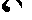 ) in der zweiten Schicht Leitermaterial (3) in ihrer Dicke reduziert werden, und zwar nur soweit, bis die vorstehenden Ränder (9,9') in der ersten Schicht Leitermaterial (1) entfernt sind und dass zugängliche Oberflächenbereiche von Leitermaterial (1,3) und zugängliche Oberflächenbereiche von ätzbaren Isolatormaterial (2) mit elektrisch leitfähigem Material (11) aufplattiert werden, so dass die verschiedenen Schichten Leitermaterial (1,3) elektrisch miteinander verbunden sind.

4. Verfahren gemäss einem der Ansprüche 1 bis 3, **dadurch gekennzeichnet,** dass im zweiten Verfahrensschritt die Schichten Leitermaterial (1,3) auf allen für Chemikalien zugänglichen Oberflächenbereichen solange chemisch geätzt oder elektrochemisch abgetragen werden, bis dass die vorstehenden Ränder (9,9') chemisch durchgeätzt oder elektrochemisch abgetragen sind und Hinterätzungen somit kontrolliert aufgehoben sind.

5. Verfahren gemäss einem der Ansprüche 1 bis 4, **dadurch gekennzeichnet,** dass in weiteren Verfahrensschritten zugängliche Oberflächenbereiche von Leitermaterial (1,3) und zugängliche Oberflächenbereiche von ätzbaren Isolatormaterial (2) durch aufplattiertes elektrisch leitfähigem Material (11) mechanisch mit elektrisch leitfähigem Material (11) verstärkt werden.

6. Verfahren gemäss Anspruch 5, **dadurch gekennzeichnet,** dass die Öffnungen (8,8') im Isolatormaterial (2) in diesen weiteren Verfahrensschritten vollständig mit elektrisch leitfähigem Material (11) bedeckt werden und Durchplattierungen (13,13') bilden.

7. Verfahren gemäss Anspruch 5 oder 6, **dadurch gekennzeichnet,** dass die mit elektrisch leitfähigem Material (11) aufplattierten Oberflächenbereiche Schichten Leitermaterial (1,3) und dass die mit elektrisch leitfähigem Material (11) aufplattierten Oberflächenbereiche ätzbaren Isolatormaterials (2) in weiteren Herstellungsschritten gemäss einem Schaltungsentwurf ein- und/oder zweiseitig in Stromfade mit Durchplattierungen strukturiert werden.

8. Verfahren gemäss Anspruch 1 oder 3, **dadurch gekennzeichnet,** dass als ätzbares Isolatormaterial (2) eine organische dielektrische Folie plasmageätzt oder chemisch geätzt wird, dass als Leitermaterial (1,3) beidseitig auf die organische dielektrische Folie kaschierte Kupferschichten nasschemisch geätzt oder elektroplattiert werden, dass die organische dielektrische Folie 25-50 µm dick ist und dass die Kupferschichten 8 bis 12 µm dick sind.

9. Verfahren gemäss Anspruch 8, **dadurch gekennzeichnet,** dass als organische dielektrische Folien Polyimidfolien oder Folien aus Liquid Crystal Polymers verwendet werden.

10. Verfahren gemäss Anspruch 8, **dadurch gekennzeichnet,** dass als organische dielektrische Folien aramidfaserverstärkte Laminate aus Epoxyd- oder Polyimidharzfolien verwendet werden.

11. Verfahren gemäss Anspruch 8, **dadurch gekennzeichnet,** dass als organische dielektrische Folien aramidfaserverstärkte Laminate aus Cyanat-Ester-Harzfolien verwendet werden.

12. Verfahren gemäss Anspruch 5, **dadurch gekennzeichnet,** dass als elektrisch leitfähiges Material (11) dünne Metallschichten aus Kupfer oder Pallädium aufplattiert werden.

13. Zwischenprodukt (Z) für Leiterplatten und Folienleiterplatten, herstellbar nach dem Verfahren gemäß Anspruch 1.

14. Zwischenprodukt (Z) gemäss Anspruch 13, **dadurch gekennzeichnet,** dass die zweite Schicht Leitermaterial (3) im Bereich der Böden (10,10') der Öffnungen (8,8') verglichen mit anderen Bereichen der weiteren Schicht Leitermaterial (3) um die Hälfte dickenreduziert ist.

15. Zwischenprodukt (Z) gemäss Anspruch 13, **dadurch gekennzeichnet,** dass die zweite Schicht Leitermaterial (3) im Bereich der Böden (10,10') der Öffnungen (8,8') sowie exponierte Bereiche der ersten Schicht Leitermaterial (1) gleich dickenreduziert ist.

16. Leiterplatten und Folienleiterplatten, herstellbar nach dem Verfahren gemäß Anspruch 3.

## Claims

1. Method for producing intermediates (Z) for circuit boards and film circuit boards from starting products (A) made of etchable insulating (2) which are laminated onto a carrier substrate (4), which insulating material (2) is coated on both sides with one layer of conductor material (1, 3), whereby in a first method stage openings (8, 8') are etched into the insulating material (2) in accordance with prepared openings (7, 7') in the first layer of conductor material (1), whereby these openings (8, 8') in the etchable insulating material (2) reach under the edges of the prepared openings (7, 7') in the first layer and projecting edges (9, 9') are formed in the first layer of conductor material (1) and these openings (8, 8') in the etchable insulating material (2) reach to the second layer of conductor material (3) and bottoms (10, 10') of the openings (8, 8') are formed by this second layer of conductor material (3), **characterized** in that in the first method stage the openings (8, 8') in the etchable insulating material (2) are produced with so much aimed back etching by means of chemical etching or plasma-etching that oblique photochemically structurable walls (14, 14') in relation to the flat extension of the starting product (A) are achieved, that in a second method stage the layers of conductor material (1, 3) are, in accordance to the local surface/volume ratios, removed by means of wet chemical etching or electrochemically by regular reduction of thickness, whereby simultaneously exposed regions of the first layer of conductor material (3) are reduced in their thickness, this only as far as the protruding edges (9, 9') in the first layer of conductor material are removed.

2. Method according to claim 1, **characterized** in that intermediates produced in this manner are plated with electrically conductive material (11) such that the different layers of conductor material (1, 3) are connected in an electrically conductive manner.

3. Method for production of circuit boards and film circuit boards from starting products (A) laminated onto a carrier substrate (4) which starting products (A) are made of etchable insulating material (2), which insulating material (2) is coated on both sides with a layer of carrier material (1, 3), whereby in a first method stage openings (8, 8') in the etchable insulating material (2) are etched in accordance with openings (7, 7') in the first layer of conductor material (1), whereby these openings (8, 8') in the etchable insulating material reach under the edges of the prepared openings (7, 7') in the first layer of conductor material (1) and projecting edges (9, 9') are formed in the first layer of conductor material (1) and these openings (8, 8') in the etchable insulating material (2) reach up to the second layer of conductor material (3) and bottoms (10, 10') of openings (8, 8') are formed by this second layer of conductive material (3), **characterized** in that in a first method stage the openings (8, 8') are produced with so much aimed back etching by means of chemical etching or plasma-etching that oblique photochemically structurable walls (14, 14') in relation to the flat extension of the starting product (A) are achieved, that in a second method stage the layers of conductor material (1, 3) are, in accordance to the local surface/volume ratios, removed by means of wet chemical etching or electrochemically by regular reduction of thickness, whereby exposed regions of the first layer of conductor material (3) are reduced in their thickness, this only as far as the projecting edges (9, 9') in the first layer of conductor material are removed and that accessible surface regions of conductor material (1, 3) and accessible surface regions of etchable insulating material (2) are plated with conductive material (11) such that the different layers of conductor material (1, 3) are electrically connected.

4. Method according to one of claims 1 to 3, **characterized** in that in the second method stage the layers of conductive material (1, 3) are chemically etched or electrochemically removed on all surfaces accessible to chemicals until the projecting edges (9, 9') are chemically etched through or electrochemically removed and etch-backs are consequently removed in a controlled manner.

5. Method according to one of claims 1 to 4, **characterized** in that in further method stages accessible surface regions of conductor material (1,3) and accessible areas of etchable insulating material (2) are mechanically reinforced by means of plated electrically conductive material (11).

6. Method according to claim 5, **characterized** in that the openings (8, 8') in the insulating material (2) in said further process stages are completely covered with electrically conductive material (11) and form interfacial connections (13, 13').

7. Method according to claim 5 or 6, **characterized** in that the surface regions of the layers of conductive material plated with electrically conductive material (11) and the surface areas of insulating material (2) plated with electrically conductive material (11) are structured according to a circuit design on one and/or two sides in current paths with interfacial connections during the further production stages.

8. Method according to claim 1 or 3, **characterized** in that as etchable insulating material (2) an organic dielectric film is plasma-etched or chemically etched, that as conductor material (1, 3) copper layers clad on both sides on the organic, dielectric film are chemically etched on both sides, that the organic, dielectric film is 25 to 50µm thick and that the copper layers are 8 to 12 µm thick.

9. Process according to claim 8, **characterized** in that as organic, dielectric films polyimide films or liquid crystal polymer films are used.

10. Process according to claim 8, **characterized** in that the organic, dielectric films are constituted by aramide fiber-reinforced laminates of epoxy or polyimide resin films.

11. Process according to claim 8, **characterized** in that as organic, dielectric films aramide fiber-reinforced laminates of cyanate-ester resin films are used.

12. Method according to claim 5, **characterized** in that as electrically conductive material (11) thin metal layers of copper or palladium are plated on.

13. Intermediate (Z) for circuit boards and film circuit boards producible according to the method according to claim 1

14. Intermediate (Z) according to claim 13, **characterized** in that the second layer of conductor material (3) is, in the vicinity of the bottoms (10, 10') of the openings (8, 8'), reduced in thickness by half compared to other regions of the further layer of conductor materials (3).

15. Intermediate (Z) according to claim 13, **characterized** in that the second layer of conductor material (3), in the vicinity of the bottoms (10, 10') of the openings (8, 8'), as well as exposed regions of the first layer of conductor material (1) are equally reduced in thickness.

16. Circuit boards and film circuit boards, producible according to the method according to claim 3.

## Revendications

1. Procédé de fabrication de produits intermédiaires (Z) pour cartes de circuits imprimés et pour cartes de circuits imprimés en feuilles, à partir de produits de départ (A) terminés sur un substrat porteur (4) et conçus en un matériau isolant pouvant être gravé (2), lequel matériau isolant (2) est recouvert des deux côtés à chaque fois par une couche en un matériau conducteur (1, 3),
dans lequel, lors d'une première étape du procédé, on grave par attaque des ouvertures (8, 8') dans le matériau isolant pouvant être gravé (2) selon des ouvertures préparées (7, 7') dans la première couche de matériau conducteur (1), ces ouvertures (8, 8') dans le matériau isolant pouvant être gravé (2) arrivant sous les bords des ouvertures préparées (7, 7') dans la première couche de matériau conducteur (1), des bords saillants (9, 9') étant formés dans la première couche de matériau conducteur (1), ces ouvertures (8, 8') dans le matériau isolant pouvant être gravé (2) arrivant jusqu'à la deuxième couche de matériau conducteur (3) et des fonds (10, 10') des ouvertures (8, 8') étant formés par cette deuxième couche de matériau conducteur (3),
caractérisé en ce que
lors d'une première étape du procédé, on fabrique les ouvertures (8, 8') dans le matériau isolant pouvant être gravé (2) avec une telle gravure en contre-dépouille au moyen d'une attaque chimique ou plasmatique que des parois obliques (14, 14') pouvant être structurées par photochimie peuvent être obtenues par rapport à l'étendue plane du produit de départ (A), lors d'une deuxième étape du procédé, on enlève les couches de matériau conducteur (1, 3) selon les rapports locaux surfaces/volumes au moyen d'une gravure par voie chimique humide ou, de façon électrochimique, par une réduction d'épaisseur régulière, des zones exposées en même temps de la première couche de matériau conducteur (1) ainsi que les fonds (10, 10') dans la deuxième couche de matériau conducteur (3) étant réduits quant à leur épaisseur, et ce seulement jusqu'à ce que les bords saillants (9, 9') dans la première couche de matériau conducteur (1) soient enlevés.

2. Procédé selon la revendication 1, caractérisé en ce qu'on double de matériau électriquement conducteur (11) des produits intermédiaires ainsi fabriqués (Z) de telle sorte que les différentes couches de matériau conducteur (1, 3) sont reliées électriquement entre elles.

3. Procédé de fabrication de cartes de circuits imprimés et de cartes de circuits imprimés en feuilles, à partir de produits de départ (A) terminés sur un substrat porteur (4) et conçus en un matériau isolant pouvant être gravé (2), lequel matériau isolant (2) est recouvert des deux côtés à chaque fois par une couche en un matériau conducteur (1, 3),
dans lequel, lors dune première étape du procédé, on grave par attaque des ouvertures (8, 8') dans le matériau isolant pouvant être gravé (2) selon des ouvertures préparées (7, 7') dans la première couche de matériau conducteur (1), ces ouvertures (8, 8') dans le matériau isolant pouvant être gravé (2) arrivant sous les bords des ouvertures préparées (7, 7') dans la première couche de matériau conducteur (1), des bords saillants (9, 9') étant formés dans la première couche de matériau conducteur (1), ces ouvertures (8, 8') dans le matériau isolant pouvant être gravé (2) arrivant jusqu'à la deuxième couche de matériau conducteur (3) et des fonds (10, 10') des ouvertures (8, 8') étant formés par cette deuxième couche de matériau conducteur (3),
caractérisé en ce que
lors d'une première étape du procédé, on fabrique les ouvertures (8, 8') dans le matériau isolant pouvant être gravé (2) avec une telle gravure en contre-dépouille au moyen d'une attaque chimique ou plasmatique que des parois obliques (14, 14') pouvant être structurées par photochimie peuvent être obtenues par rapport à l'étendue plane du produit de départ (A), lors d'une deuxième étape du procédé, on enlève les couches de matériau conducteur (1, 3) selon les rapports locaux surfaces/volumes au moyen d'une gravure par voie chimique humide ou, de façon électrochimique, par une réduction d'épaisseur régulière, des zones exposées de la première couche de matériau conducteur (1) ainsi que les fonds (10, 10') dans la deuxième couche de matériau conducteur (3) étant réduits quant à leur épaisseur, et ce seulement jusqu'à ce que les bords saillants (9, 9') dans la première couche de matériau conducteur (1) soient enlevés et on double de matériau électriquement conducteur (11) des zones de surface accessibles de matériau conducteur (1, 3) et des zones de surface accessibles de matériau isolant pouvant être gravé (2) de telle sorte que les différentes couches (1, 3) sont reliées électriquement entre elles.

4. Procédé selon l'une des revendications 1 à 3, caractérisé en ce que, lors de la deuxième étape du procédé, on attaque par chimie ou on enlève par électrochimie les couches de matériau conducteur (1, 3) sur toutes les zones de surface accessibles pour des produits chimiques jusqu'à ce que les bords saillants (9, 9') soient complètement attaqués par chimie ou enlevés par électrochimie et donc jusqu'à ce que des gravures en contre-dépouille soient supprimées de manière contrôlée.

5. Procédé selon l'une des revendications 1 à 4, caractérisé en ce que, dans d'autres étapes du procédé, on renforce des zones de surface accessibles de matériau conducteur (1, 3) et des zones de surfaces accessibles de matériau isolant pouvant être gravé (2) par un matériau électriquement conducteur doublé (11), et ce mécaniquement avec un matériau électriquement conducteur (11).

6. Procédé selon la revendication 5, caractérisé en ce que les ouvertures (8, 8') dans le matériau isolant (2) dans des autres étapes du procédé sont complètement recouvertes de matériau électriquement conducteur (11) et forment des métallisations (13, 13').

7. Procédé selon la revendication 5 ou 6, caractérisé en ce que, lors d'autres étapes du procédé, selon un projet de circuit, on structure les zones de surface, doublées de matériau électriquement conducteur (11), de couches de matériau conducteur (1, 3) et les zones de surface, doublées de matériau électriquement conducteur (11), de matériau isolant pouvant être gravé (2) d'un ou des deux côtés en voies de courant avec des métallisations.

8. Procédé selon la revendication 1 ou 3, caractérisé en ce que, comme matériau isolant pouvant être gravé (2), on attaque par plasma ou par chimie une feuille diélectrique organique, en ce que, comme matériau conducteur (1, 3), on attaque par chimie humide ou on électro-plaque des couches de cuivre contrecollées des deux côtés sur la feuille diélectrique organique, en ce que la feuille diélectrique organique a une épaisseur de 25 à 50 µm et en ce que les couches de cuivre ont une épaisseur de 8 à 12 µm.

9. Procédé selon la revendication 8, caractérisé en ce qu'on utilise comme feuilles diélectriques organiques des feuilles de polyimide ou des feuilles de polymère à cristal liquide.

10. Procédé selon la revendication 8, caractérisé en ce qu'on utilise comme feuilles diélectriques organiques des stratifiés en feuilles de résine époxyde ou de résine polyimide et renforcés par fibres d'aramide.

11. Procédé selon la revendication 8, caractérisé en ce qu'on utilise comme feuilles diélectriques organiques des stratifiés en feuilles de résine à esters de cyanat et renforcés par fibres d'aramide.

12. Procédé selon la revendication 5, caractérisé en ce que, comme matériau électriquement conducteur (11), on plaque de minces feuilles métalliques en cuivre ou en palladium.

13. Produit intermédiaire (Z) pour cartes de circuits imprimés et pour cartes de circuits imprimés en feuilles, pouvant être fabriqué selon le procédé selon la revendication 1.

14. Produit intermédiaire (Z) selon la revendication 13, caractérisé en ce que la deuxième couche de matériau conducteur (3) dans la zone des fonds (10, 10') des ouvertures (8, 8') est, comparée à d'autres zones de la deuxième couche de matériau conducteur (3), réduite de moitié en épaisseur.

15. Produit intermédiaire (Z) selon la revendication 13, caractérisé en ce que la deuxième couche de matériau conducteur (3) dans la zone des fonds (10, 10') des ouvertures (8, 8') ainsi que des zones exposées de la première couche de matériau conducteur (1) sont réduites en épaisseur de façon identique.

16. Cartes de circuits imprimés et cartes de circuits imprimés en feuilles, pouvant être fabriquées selon le procédé selon la revendication 3.
